**Europäisches Patentamt**

**European Patent Office**

**Office européen des brevets**

(19)

(11) Veröffentlichungsnummer: **0 100 408 B1**

# EUROPÄISCHE PATENTSCHRIFT

(12)

(45) Veröffentlichungstag der Patentschrift: **18.03.92**

(51) Int. Cl.⁵: **H04N 5/57**, H03G 1/02

(21) Anmeldenummer: **83105365.7**

(22) Anmeldetag: **31.05.83**

(54) Einrichtung zum Einstellen einer Steuergrösse.

(30) Priorität: **06.07.82 DE 3225205**

(43) Veröffentlichungstag der Anmeldung:
**15.02.84 Patentblatt 84/07**

(45) Bekanntmachung des Hinweises auf die
Patenterteilung:
**18.03.92 Patentblatt 92/12**

(84) Benannte Vertragsstaaten:
**AT BE CH FR GB IT LI LU NL SE**

(56) Entgegenhaltungen:
**DE-A- 2 716 564**
**DE-A- 2 746 552**
**GB-A- 2 054 994**
**US-A- 3 961 281**

**FUNKSCHAU, Band 52, Nr. 5, Februar 1980,
Seiten 47-50; München, DE; P. LÖSER:
"Lautstärkeregelung mit CMOS-
Digital/Analog-Wandler"**

**ELECTRONIC COMPONENTS AND APPLICA-
TIONS, Band 2, Nr. 1, November 1979, Seiten
2-15, Eindhoven, NL; U. SCHILLHOF: "Digital
control of radio and audio equipment"**

(73) Patentinhaber: **Deutsche Thomson-Brandt
GmbH**
**Hermann-Schwer-Strasse 3 Postfach 1307**
**W-7730 Villingen-Schwenningen(DE)**

(72) Erfinder: **Zimmermann, Horst**
**Kirschbaumstrasse 7**
**W-7730 VS-Marbach(DE)**
Erfinder: **Otto, Bernhard**
**Überruckweg 13**
**W-7730 VS-Rietheim(DE)**

EP 0 100 408 B1

**Beschreibung**

Die Erfindung bezieht sich auf eine Einrichtung zum Einstellen einer Steuergröße, beispielsweise zum Einstellen der Lautstärke in einem Rundfunkgerät oder von Farbsättigung und Helligkeit in einem Fernsehgerät, wobei die Steuergröße in einem ersten Variationsbereich (I) voreinstellbar ist und in einem zweiten Variationsbereich (II) in digitalen Schritten von der Voreinstellung aus veränderbar ist.

Aus der DE-A-27 46 552 ist es bekannt, in einen ersten Variationsbereich eine Voreinstellung für eine Steuergröße vorzunehmen, wobei mit Hilfe eines mechanisch einstellbaren Analog-Potentiometers dessen unterschiedlicher Widerstand oder dessen unterschiedlich groß abgegriffene Spannung für diese Grundeinstellung herangezogen wird, wohl zum Ausgleich von Toleranzen sowie zur Anpassung an den individuellen Geschmack. In einem zweiten Variationsbereich ist die Steuergröße von dem voreingestellten Wert aus in digitalen Schritten veränderbar.

Diese bekannte Schaltungsmaßnahme erfordert einen unnötig hohen Aufwand an Bauteilen und an Abgleicharbeiten.

Auch aus der US-A-3 961 281 ist eine Schaltungsanordnung bekannt, bei der eine Steuergröße zu Einstellzwecken in digitalen Schritten veränderbar ist. Aufgrund einer Besonderheit der Schaltungsanordnung, derzufolge ein fester Spannungsteiler und eine Diode zusammenarbeiten, ändert sich die Steuergröße in einem ersten Bereich pro digitalem Schritt wesentlich stärker als in einem zweiten Bereich. Die Aufteilung zwischen dem ersten und dem zweiten Bereich ist ebenfalls von der Schaltung her fest vorgegeben und unveränderbar.

Es ist auch bekannt, bei digitaler Einstellung von Steuergrößen Impulse mit schrittweise veränderbarem Tastverhältnis zu bilden, wobei die Impulse nach einer Digital-Analog-Wandlung in die entsprechende Stellgröße in analoger Form gebildet werden.

Der Erfindung liegt die Aufgabe zugrunde, den oben erwähnten zusätzlichen Aufwand an Bauteilen und an Einstellarbeiten zu vermeiden.

Diese Aufgabe wird durch die im Anspruch 1 angegebenen Merkmale gelöst.

Dabei ist es von Vorteil, daß sowohl das Einstellen des Grundeinstellwertes (Variationsbereich I) als auch das Einstellen der Steuergröße von dieser Voreinstellung aus (Variationsbereich II) mit Hilfe derselben Einrichtung erfolgen kann, somit die im Stand der Technik für den Variationsbereich I eigens erforderliche - variable oder feste - Potentiometerschaltung entfällt.

Weiterbildungen der Erfindung sind in den abhängigen Ansprüchen beansprucht.

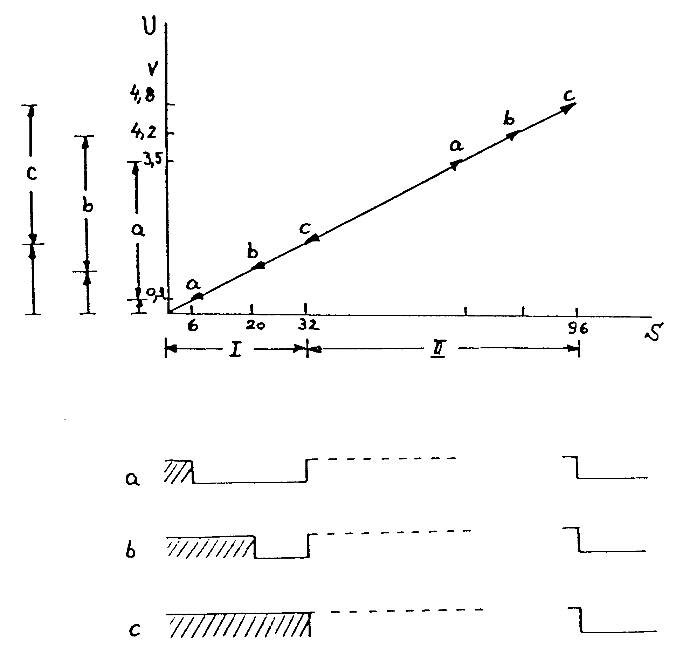

Weitere Einzelheiten der Erfindung werden nachstehend anhand der Zeichnung an einem Ausführungsbeispiel erörtert.

Der gesamte Einstellbereich erstrecke sich von 0 bis 4,8 Volt. Es sei als Beispiel angenommen, daß dieser Bereich in 96 Schritte unterteilt wird. Dann ergibt sich eine Spannungsänderung $\Delta$ U von 50 mV/Schritt. Der gesamte Bereich wird nun erfindungsgemäß in zwei Teilbereiche I und II aufgeteilt, von denen der Bereich I 32 Schritte und der Bereich II 64 Schritte umfaßt. Der Bereich I dient zur Grundeinstellung, wogegen der Bereich II für die Einstellung der Steuergrößen zur Verfügung steht. Je nach Anzahl der Schritte S im Bereich I ändern sich der Grundeinstellwert U von dem die Einstellung ausgeht. Dieser Grundeinstellwert ist praktisch der Offset für die Einstellung der Steuergröße.

In Beispiel a werden 6 Schritte des Bereichs I als Grundeinstellung gewählt, so daß die Einstellung von 0,3 Volt beginnt und schrittweise bis 3,5 Volt veränderbar ist. In gleicher Weise ergeben sich bei b für 20 Schritte Grundeinstellung des Bereichs I ein Ausgangswert von 1 Volt, so daß die Einstellung bis 4,2 Volt reicht und schließlich bei c beginnt die Einstellung nach 32 Schritte bei 1,6 Volt und erreicht bei 4,8 Volt ihren Höchstwert. Die eingestellten Impulsbreiten für Grundeinstellung und Einstellwert können digital gespeichert werden.

Die abgespeicherten Werte können hierbei als aus zwei Teilen bestehenden Wort (5 bit für die Grundeinstellung und 6 bit für die Steuergröße) digital ausgegeben weiterverarbeitet werden. Es kann auch der abgespeicherte digitale Wert erst nach einer Digital-Analog-Wandlung zur Erzeugung der Steuergröße weiterverarbeitet werden.

Die Erfindung bringt den technischen Vorteil, daß der Schaltungsaufwand für die Grundeinstellung gering ist, deren Abgleich für die Fertigung wesentlich erleichtert wird, wobei auch der Benutzer des Empfängers diesen Grundeinstellwert leicht und seinem Geschmack entsprechend verändern kann.

**Patentansprüche**

1. Einrichtung zum Einstellen einer Steuergröße, in einem Gerät der Unterhaltungselektronik beispielsweise zum Einstellen der Lautstärke in einem Rundfunkgerät oder von Farbsättigung und Helligkeit in einem Fernsehgerät, wobei die Steuergröße in einem ersten Variationsbereich (I) als Grundeinstellwert voreinstellbar ist und in einem zweiten Variationsbereich (II) mittels einer Fernbedienung in diskreten Schritten von der Voreinstellung aus veränderbar ist, dadurch gekennzeichnet, daß die Steuergröße in dem ersten Variationsbereich (I) in diskreten Schritten veränderbar ist, daß die hierbei gewählte Anzahl von Schritten als der Grundeinstellwert digital abspeicherbar ist, daß dieser Grundeinstellwert den Anfangswert für den zweiten Variationsbereich (II) darstellt, daß jeder diskrete Schritt unabhängig von dem jeweiligen Variationsbereich (I, II) eine gleich große Schrittweite aufweist und daß ein Speicher vorgesehen ist, in den die Anzahl der eingestellten Schritte für jeden der beiden Variationsbereiche (I, II) digital abspeicherbar ist.

2. Einrichtung nach Anspruch 1, dadurch gekennzeichnet, daß die abgespeicherten Werte für die Einstellgrößen digital weiterverarbeitet werden.

3. Einrichtung nach Anspruch 1, dadurch gekennzeichnet, daß die abgespeicherten Werte für die Einstellgrößen nach einer Digital-Analog-Wandlung weiterverarbeitet werden.

**Claims**

1. Device for the adjustment of a controlled variable in a consumer electronics device, for example the sounds level adjustment of a radio or the colour saturation or brightness adjustment of a television, whereby the controlled variable can be preset as a basic setting in an initial variation range (I) and in a second variation range (II) can be varied in discrete steps from this basic setting by remote control, characterised in that the controlled variable is variable in the first variation range (I) in discrete steps, in that the number of steps hereby selected can be stored digitally to define the basic setting, in that this basic setting represents the lower range value for the second variation range (II), in that each discrete step, independent of the variation range (I,II), has an identical step size and in that a storage device is provided in which the number of step settings can be stored digitally for each of the two variation ranges (I,II).

2. Device as claimed in claim 1 characterised in that the stored values for the controlled variables are processed digitally.

3. Device as claimed in claim 1 characterised in that the stored values for the controlled variables are processed by digital-to-analog conversion.

**Revendications**

1. Dispositif pour le réglage d'une variable réglante dans un appareil du domaine de l'électronique de loisirs, par exemple pour le réglage de l'intensité sonore dans un appareil de radio ou de la saturation de couleur et de l'intensité lumineuse dans un appareil de télévision, la grandeur réglante pouvant être préréglés comme valeur de réglage de base dans une première plage de variation (I) et pouvant être variée à partir de la valeur de préréglage dans une seconde plage de variation (II) en pas discrets à l'aide d'une télécommande, caractérisé en ce que la variable réglante peut varier dans la premiére plage de variation (I) en pas discrets, que le nombre de pas ici sélectionné peut être mis en mémoire numériquement en tant que valeur de réglage de base, que cette valeur de réglage de base représente la valeur initiale pour la seconde plage de variation (II), que chaque pas discret présente une grandeur de pas de méme dimension indépendamment de la plage de variation respective (I, II) et qu'une mémoire est prévue dans laquelle le nombre des pas réglés peut être mémorisé numériquement pour chacune des deux plages de variation (I, II).

2. Dispositif selon la revendication 1, caractérisé en ce que les valeurs mémorisées pour les grandeurs de réglage sont traitées numériquement.

3. Dispositif selon la revendication 1, caractérisé en ce que les valeurs mémorisées pour les grandeurs de réglage sont traités selon une conversion numérique-analogique.